# EUROPEAN PATENT APPLICATION

(11) **EP 4 113 590 A1**
(43) Date of publication of application: **04.01.2023**
(21) Application number: 21761127.6
(22) Date of filing: 19.02.2021
(51) Int. Cl.: H01L 23/12, H01L 33/48

(54) **ELECTRONIC COMPONENT MOUNTING PACKAGE AND ELECTRONIC DEVICE**

(30) Priority: 26.02.2020 JP 2020030613
(71) Applicant: Kyocera Corporation, Kyoto-shi Kyoto 612-8501 (JP)
(72) Inventor: SUGAI,Kouichirou, Kyoto-shi, Kyoto 612-8501 (JP); NISHIMOTO,Kazuki, Kyoto-shi, Kyoto 612-8501 (JP)
(74) Representative: Viering, Jentschura & Partner mbB Patent- und Rechtsanwälte
(86) International application number: PCT/JP2021/006248
(87) International publication number: WO 2021/172178

(57) **Abstract**

An electronic component mounting package 1 is provided with a metal substrate 11 including a first surface, a recessed portion 12 opening on the first surface, and a mounting portion for an electronic component 2 in the recessed portion 12, and a wiring conductor 42 located on the first surface via an insulation layer 41 other than at the opening of the recessed portion 12, and a metal oxide film 12a is included on at least a part of the inner side surface of the recessed portion 12.

## Description

### Technical Field

The present disclosure relates to an electronic component mounting package and an electronic device.

### Background Art

Conventionally, in a case where a light emitting element is used as an electronic component, an electronic component mounting substrate including a recessed portion is used (see, for example, JP 2013-122189 A).

### Summary of Invention

An electronic component mounting package of the present disclosure is provided with a metal substrate including a first surface, a recessed portion opening on the first surface, and a mounting portion for an electronic component in the recessed portion, and a wiring conductor located on the first surface via an insulation layer other than at the opening of the recessed portion, wherein a metal oxide film is included on at least a part of an inner side surface of the recessed portion.

An electronic device of the present disclosure includes the electronic component mounting package having the configuration described above and an electronic component mounted on the electronic component mounting package.

### Brief Description of Drawings

FIG. 1A is a top view illustrating an electronic component mounting package according to a first embodiment.
FIG. 1B is a top view illustrating a metal substrate of the electronic component mounting package in FIG. 1A.
FIG. 2A is a cross-sectional view taken along line A-A of the electronic component mounting package illustrated in FIG. 1A.
FIG. 2B is an enlarged cross-sectional view of a main portion in a part A in FIG. 2A.
FIG. 3 is a cross-sectional view illustrating an electronic device in which an electronic component is mounted on the electronic component mounting package in FIG. 1A.
FIG. 4A is a top view illustrating an electronic component mounting package according to a second embodiment.
FIG. 4B is a top view illustrating a metal substrate of the electronic component mounting package in FIG. 4A.
FIG. 5A is a cross-sectional view taken along line A-A of the electronic component mounting package illustrated in FIG. 4A.
FIG. 5B is an enlarged cross-sectional view of a main portion in a part A in FIG. 5A.

### Description of Embodiments

Several exemplary embodiments of the present disclosure will be described with reference to the accompanying drawings.

### First Embodiment

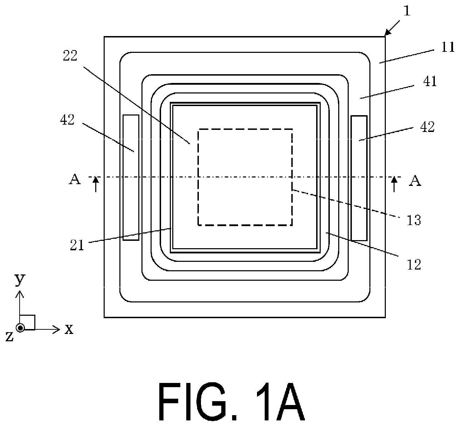

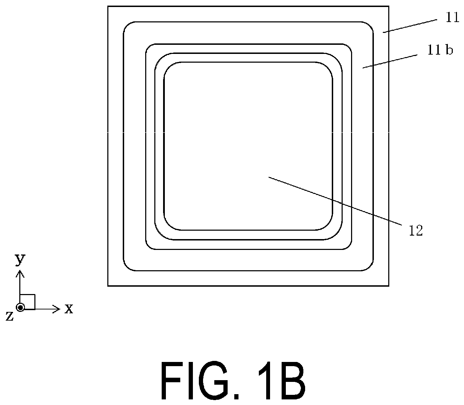

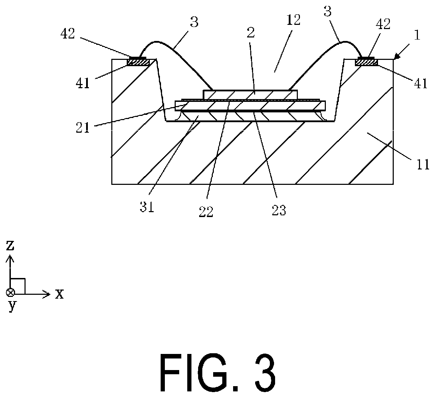

An electronic component mounting package 1 of the present disclosure according to the present embodiment is provided with a metal substrate 11 including a first surface, a recessed portion 12 opening on the first surface, and a mounting portion 13 for an electronic component 2 in the recessed portion 12, and a wiring conductor 42 located on the first surface via an insulation layer 41 other than at the opening of the recessed portion 12. The metal substrate 11 includes a metal oxide film 12a on at least a part of an inner side surface of the recessed portion 12. An insulation substrate plate 21 for mounting the electronic component 2 may be located in the mounting portion 13 of the recessed portion 12. In FIGS. 1A to 3, an upward direction is defined as a positive direction along a virtual Z axis. Note that the terms "top" and "bottom" are used in the following description by way of convenience and should not be construed as limitations in the actual use of the electronic component mounting package 1 or the like.

The metal substrate 11 includes the first surface (top surface in FIGS. 1A to 2B), the second surface (bottom surface in FIGS. 1A to 2B) on a side opposite to the first surface in a thickness direction, and side surfaces. A material having high thermal conductivity, for example, a metal material such as aluminum (Al) can be used for the metal substrate 11. Aluminum is lightweight and has a high reflectance with respect to light, and thus it is suitably used when applied to a head lamp or the like of an automobile. Furthermore, in a case where a light emitting element for ultraviolet (UV) is used as the electronic component 2, Al is suitable from a perspective that Al has excellent reflectance with respect to the light emitting element for UV and is lightweight.

As illustrated in FIGS. 1A to 2B, the metal substrate 11 includes the recessed portion 12 having a frame-like shape opening on the first surface and including a bottom surface, an inner side surface, and an outer side surface. The recessed portion 12 functions as a support for mounting and supporting the insulation substrate plate 21 on the bottom surface of the recessed portion 12. The recessed portion 12 is formed by cutting, laser machining, or the like the first surface of the metal substrate 11.

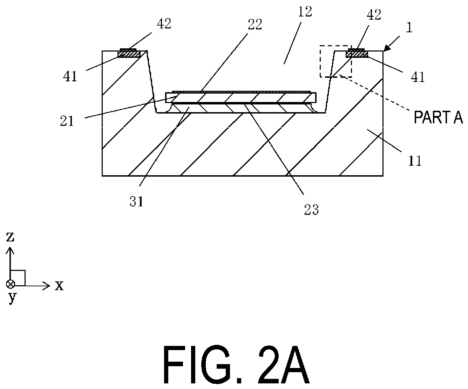

In the example illustrated in FIGS. 1A to 2B, in the recessed portion 12, the inner side surface of the recessed portion 12 is inclined so that the opening side of the recessed portion 12 becomes wider than the bottom surface side of the recessed portion 12 (in FIGS. 1A to 2B, a space having a square trapezoidal shape in which the opening side of the first surface of the metal substrate 11 becomes larger than the bottom surface side of the recessed portion 12 in plan view).

The insulation substrate plate 21 includes a third surface (top surface in FIGS. 1A to 2B), a fourth surface (bottom surface in FIGS. 1A to 2B) on a side opposite to the third surface in a thickness direction, and side surfaces. The insulation substrate plate 21 includes a single insulation layer or a plurality of insulation layers, and has a rectangular shape when viewed in plan view, that is, when viewed from a direction perpendicular to the third surface. The insulation substrate plate 21 functions as a support body for supporting the electronic component 2. The insulation substrate plate 21 includes, when viewed in plan view, a mounting layer 22 for mounting the electronic component 2 on a third surface side, and a bonding layer 23 for bonding the insulation substrate plate 21 to the metal substrate 11 on a fourth surface side.

The insulation substrate plate 21 may be made from a ceramic, such as an aluminum oxide-based sintered body (alumina ceramic), an aluminum nitride-based sintered body, a silicon nitride-based sintered body, a mullite-based sintered body, or a glass ceramic sintered body. The insulation substrate plate 21 may be made from a ceramic, such as an aluminum oxide-based sintered body (alumina ceramic), an aluminum nitride-based sintered body, a silicon nitride-based sintered body, a mullite-based sintered body, or a glass ceramic sintered body. In a configuration in which the insulation substrate plate 21 is, for example, an aluminum nitride-based sintered body, a slurry is produced by adding a suitable organic binder, a solvent, and the like to a raw material powder of aluminum nitride (AlN), erbium oxide (Er₂O₃), yttrium oxide (Y₂O₃), or the like, and then mixing the aforementioned. A ceramic green sheet is produced by forming the slurry described above into a sheet using a known doctor blade method, calender roll method, or the like. If necessary, a plurality of ceramic green sheets are laminated and fired at a high temperature (approximately 1800°C) to produce the insulation substrate plate 21 formed of a single insulation layer or a plurality of insulation layers.

As illustrated in FIGS. 1A to 2B, the mounting layer 22 is located on the third surface of the insulation substrate plate 21. The mounting layer 22 is used as a mounting portion for the electronic component 2. Alternatively, the mounting layer 22 is used as a connection portion of a connection member 3 such as a solder bump or the like, and is used for electrically connecting the electronic component 2 and a connection pad of a module substrate.

As illustrated in FIG. 2A, the bonding layer 23 is located on the fourth surface of the insulation substrate plate 21. The bonding layer 23 is used as a bonding portion such as a bonding material 31, and is used for bonding the metal substrate 11 and the insulation substrate plate 21 to each other.

The mounting layer 22 and the bonding layer 23 include a thin film layer and a plating layer. The thin film layer includes, for example, an adhesion metal layer and a barrier layer. The adhesion metal layer constituting the thin film layer is formed on the third surface or the fourth surface of the insulation substrate plate 21. The adhesion metal layer is made from, for example, tantalum nitride, nickel-chromium, nickel-chromium-silicon, tungsten-silicon, molybdenum-silicon, tungsten, molybdenum, titanium, or chromium, and is deposited on the third surface or the fourth surface of the insulation substrate plate 21 by adopting a thin film formation technique such as vapor deposition, ion plating, or sputtering. For example, in the case of forming the adhesion metal layer using a vacuum vapor deposition method, the insulation substrate plate 21 is placed in a deposition chamber of a vacuum deposition apparatus, and a metal piece to serve as the adhesion metal layer is disposed on the deposition source in the deposition chamber. Thereafter, the deposition chamber is brought into a vacuum state (pressure of 10⁻² Pa or less), and the metal piece disposed on the deposition source is heated and vaporized so that molecules of the vaporized metal piece are deposited on the insulation substrate plate 21, thereby forming a layer of thin film metal that serves as the adhesion metal layer. Then, after forming a resist pattern, using a photolithography method, on the insulation substrate plate 21 on which the layer of thin film metal is formed, an excess part of the layer of thin film metal is removed by etching to form the adhesion metal layer. The barrier layer is deposited on a top surface of the adhesion metal layer. The barrier layer has good joining properties and wettability with the adhesion metal layer and the plating layer, strongly bonds the adhesion metal layer and the plating layer, and prevents mutual diffusion between the adhesion metal layer and the plating layer. The barrier layer is made from, for example, nickel-chromium, platinum, palladium, nickel, or cobalt, and is deposited on a surface of the adhesion metal layer by a thin film formation technique such as vapor deposition, ion plating, or sputtering.

Preferably, the thickness of the adhesion metal layer is approximately from 0.01 to 0.5 µm. A thickness less than 0.01 µm tends to make it difficult to strongly adhere the adhesion metal layer to the insulation substrate plate 21. A thickness of more than 0.5 µm tends to cause the adhesion metal layer to more easily peel off due to internal stress produced in the formation of the adhesion metal layer. Preferably, the thickness of the barrier layer is approximately from 0.05 to 1 µm. When the thickness is less than 0.05 µm, a flaw such as a pinhole is more likely to occur and the barrier layer is less likely to function properly. A thickness of more than 1 µm tends to cause the barrier layer to more easily peel off due to internal stress produced in the formation of the barrier layer.

The plating layer is deposited by an electroplating method or an electroless plating method on a surface where the thin film layer is exposed. The plating layer is made from a metal, such as nickel, copper, gold, or silver, that has superior corrosion resistance and superior joining properties with the connection member 3. For example, a nickel plating layer having a thickness of approximately from 0.5 to 5 µm and a gold plating layer having a thickness of approximately from 0.1 to 3 µm are deposited in that order. This can effectively suppress corrosion of the mounting layer 22 and the bonding layer 23 and strengthen bonding between the mounting layer 22 and the connection member 3 and bonding between the bonding layer 23 and the metal substrate 11.

Furthermore, a metal layer such as copper (Cu) or gold (Au) may be disposed on the barrier layer so that the plating layer is favorably formed. The metal layer described above is formed by the same method as the thin film layer.

The bonding material 31 is located between the bottom surface of the recessed portion 12 of the metal substrate 11 and the opposite surface to the mounting surface of the insulation substrate plate 21, and bonds the bottom surface of the recessed portion 12 of the metal substrate 11 and the bonding layer 23 of the insulation substrate plate 21.

The insulation layer 41 is located around the recessed portion 12 of the metal substrate 11. The insulation layer 41 includes the wiring conductor 42 on a fifth surface (top surface in FIGS. 1A to 2B) and serves as a region for electrically connecting to an electrode of the electronic component 2. A plating layer may also be formed on an exposed surface of the wiring conductor 42. For the insulation layer 41, for example, the same ceramic as the insulation substrate plate 21 may be used, or a resin may be used.

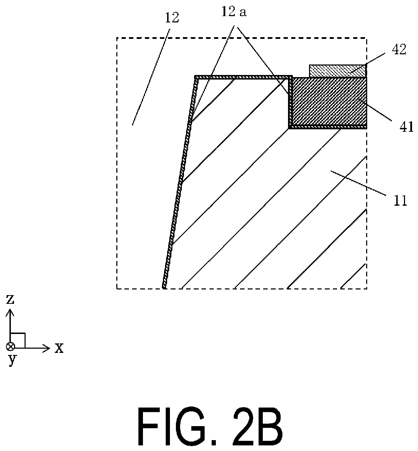

As in the example illustrated in FIG. 2B, the metal substrate 11 includes the metal oxide film 12a on the inner surface of the recessed portion 12. In a configuration in which the metal substrate 11 is made of, for example, aluminum, the metal oxide film 12a is formed from, for example, aluminum oxide. The metal oxide film 12a is formed to have a thickness of approximately 0.1 nm to 10 nm.

For example, in a configuration in which the metal substrate 11 is made of aluminum and the metal oxide film 12a is made of aluminum oxide, the recessed portion 12 is formed in the metal substrate 11 and then the inner surface of the recessed portion 12 is oxidized. Thereafter, for example, the bonding material 31 such as a solder is placed on the bottom surface of the recessed portion 12, and energy such as ultrasonic waves is applied to the bottom surface of the recessed portion 12 to bond the insulation substrate plate 21 to the bottom surface of the recessed portion 12. Furthermore, in a case where the insulation layer 41 is a ceramic, the insulation layer 41 is bonded to the metal substrate 11 in a manner similar to that of the insulation substrate plate 21 by using a material similar to the bonding material 31, for example.

An electronic device can be produced by mounting the electronic component 2 on the third surface of the insulation substrate plate 21 of the electronic component mounting package 1. The electronic component 2 mounted on the electronic component mounting package 1 is, for example, a light emitting element such as a light emitting diode (LED) for UV. Furthermore, for example, in a configuration in which the electronic component 2 is a wire-bonding electronic component 2, the electronic component 2 is fixed on the insulation substrate plate 21 by the connection member such as a low-melting point brazing material or a conductive resin, and then mounted on the electronic component mounting package 1 by electrically connecting the electrode of the electronic component 2 and the wiring conductor 42 of the insulation layer 41 via the connection member 3 such as a bonding wire. Furthermore, after electrically connecting the electrode of the electronic component 2 and the mounting layer 22, the mounting layer 22 and the wiring conductor 42 of the insulation layer 41 are electrically connected to each other, and thus the electronic component 2 is mounted on the electronic component mounting package 1. For example, in a configuration in which the electronic component 2 is of the flip-chip type, the electronic component 2 is mounted on the electronic component mounting package 1 by electrically and mechanically connecting the electrode of the electronic component 2 and the mounting layer 22 via the connection member 3 such as a solder bump, a gold bump, or a conductive resin (e.g., anisotropic conductive resin) and then electrically connecting the mounting layer 22 and the wiring conductor 42 of the insulation layer 41. When the connection member 3 such as a bonding wire is used, a bonding wire made of aluminum or the like may be used.

A plurality of the electronic components 2 may be mounted on the third surface of the insulation substrate plate 21. As needed, the electronic component 2 is encapsulated with an encapsulation member such as glass, or that is sealed with a lid made of glass, ceramics, or metal.

According to the electronic component mounting package 1 of the present embodiment, the metal substrate 11 including the first surface, the recessed portion 12 opening on the first surface, and the mounting portion 13 for the electronic component 2 in the recessed portion 12, the wiring conductor 42 located on the first surface via the insulation layer 41 other than at the opening of the recessed portion 12 are provided, and the metal oxide film 12a is included on at least a part of the inner side surface of the recessed portion 12. According to the configuration described above, in a case where the light emitting element is used as the electronic component 2, even when the inner side surface of the recessed portion 12 is irradiated with the emitted light, heat is less likely to be generated due to the metal oxide film 12a, and heat is less likely to be transferred to the insulation layer 41, and thus the insulation layer 41 is less likely to deteriorate. Thus, usage over a long period of time is possible. In a case where the insulation layer 41 is a resin, it is susceptible to heat, and thus the above-described configuration makes it easier to obtain the effect of making the insulation layer 41 less likely to deteriorate, and the same applies in the following disclosure.

The metal oxide film 12a is located from the opening of the recessed portion 12 to the height of the mounting portion 13 on the inner side surface of the recessed portion 12. According to the configuration described above, even when the inner side surface of the recessed portion 12 is irradiated with the emitted light from the side of the mounting portion 13 to the opening of the recessed portion 12 between the light emitting element and the insulation layer 41 in a vertical cross-sectional view, heat is less likely to be generated due to the metal oxide film 12a, and heat is less likely to be transferred to the insulation layer 41, and thus the insulation layer 41 is less likely to deteriorate. Thus, usage over a long period of time is possible.

Furthermore, the metal oxide film 12a is located along the length direction of the insulation layer 41. According to the configuration described above, even when the inner side surface of the recessed portion 12 is irradiated with the light emitted over the entire length direction of the insulation layer 41, heat is effectively less likely to be generated due to the metal oxide film 12a, and heat is less likely to be transferred to the insulation layer 41, and thus the insulation layer 41 is less likely to deteriorate. Thus, usage over a long period of time is possible.

Furthermore, over the entire circumference of the recessed portion 12, the metal oxide film 12a is located from the opening of the recessed portion 12 to the height of the mounting portion 13 on the inner side surface of the recessed portion 12. According to the configuration described above, even when the inner side surface of the recessed portion 12 is irradiated with the light emitted over the entire circumference of the recessed portion 12, heat is more effectively less likely to be generated due to the metal oxide film 12a, and heat is less likely to be transferred to the insulation layer 41, and thus the insulation layer 41 is less likely to deteriorate. Thus, usage over a long period of time is possible.

The inner side surface of the recessed portion 12 is inclined so that the opening of the recessed portion 12 is located outside a boundary between the bottom surface of the recessed portion 12 and the inner side surface connected to the bottom surface. According to the configuration described above, on the opening side of the recessed portion 12, the inner side surface on the opening side of the recessed portion 12 is more obliquely irradiated with the emitted light, heat is further less likely to be generated on the opening side, and heat is further less likely to be transferred to the insulation layer 41, and thus the insulation layer 41 is less likely to deteriorate. Thus, usage over a long period of time is possible.

As in the example illustrated in FIG. 2B, the metal oxide film 12a further extends to the insulation layer 41. According to the configuration described above, heat is less likely to be transferred to the insulation layer 41, and the insulation layer 41 is less likely to deteriorate. Thus, usage over a long period of time is possible. Note that, as in the example illustrated in FIG. 2B, the metal oxide film 12a may be further located between the insulation layer 41 and the metal substrate 11. According to the configuration described above, the bond between the metal oxide film 12a and the insulation layer 41 is stronger, and thus usage over a long period of time is possible.

The metal oxide film 12a is located so as to overlap the entirety of the insulation layer 41 in plan view. According to the configuration described above, heat is less likely to be transferred to the entirety of the insulation layer 41, and the insulation layer 41 is less likely to deteriorate. Thus, usage over a long period of time is possible.

Furthermore, as in the example illustrated in FIGS. 1A to 2B, the insulation layer 41 is located inside a stepped portion 11b located on the first surface of the metal substrate 11. According to the configuration described above, the insulation layer 41 is less likely to be directly irradiated with the light of the light emitting element, and the insulation layer 41 is less likely to deteriorate. Thus, usage over a long period of time is possible.

### Second Embodiment

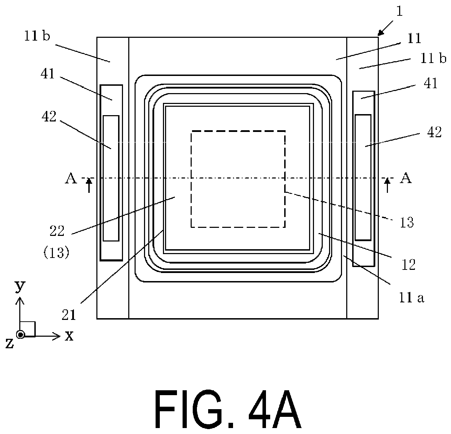

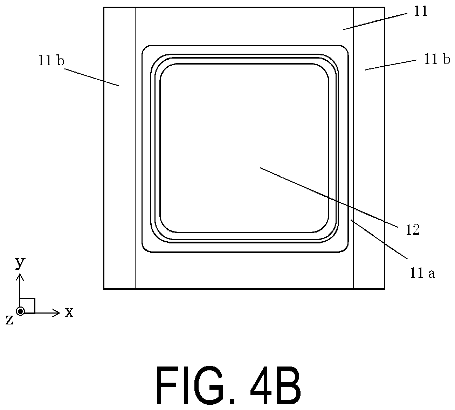

An electronic component mounting package 1 according to a second embodiment will be described next with reference to FIGS. 4A to 5B.

The electronic component mounting package 1 according to the second embodiment differs from the electronic component mounting package 1 according to the embodiment described above in that the metal substrate 11 includes a protruding portion 11a protruding from the first surface between the opening in the recessed portion 12 and the insulation layer 41, and the metal oxide film 12a is located from the inner side surface of the recessed portion 12 to the protruding portion 11a. According to the configuration described above, in a case where the light emitting element is used as the electronic component 2, even when the protruding portion 11a is further irradiated with the emitted light, heat is less likely to be generated due to the metal oxide film 12a, and heat is less likely to be transferred to the insulation layer 41, and thus the insulation layer 41 is less likely to deteriorate. Thus, usage over a long period of time is possible.

According to the electronic component mounting package 1 of the second embodiment, similar to the electronic component mounting package 1 according to the embodiment described above, the metal substrate 11 including the first surface, the recessed portion 12 opening on the first surface, and the mounting portion 13 for an electronic component 2 in the recessed portion 12, and the wiring conductor 42 located on the first surface via the insulation layer 41 other than at the opening of the recessed portion 12 are provided, and the metal oxide film 12a is included on at least a part of the inner side surface of the recessed portion 12. According to the configuration described above, in a case where the light emitting element is used as the electronic component 2, even when the inner side surface of the recessed portion 12 is irradiated with the emitted light, heat is less likely to be generated due to the metal oxide film 12a, and heat is less likely to be transferred to the insulation layer 41, and thus the insulation layer 41 is less likely to deteriorate. Thus, usage over a long period of time is possible.

The metal oxide film 12a covers the protruding portion 11a. According to the configuration described above, in a case where the light emitting element is used as the electronic component 2, even when the protruding portion 11a is further irradiated with the emitted light, the protruding portion 11a is at a location closer to the insulation layer 41 than the inner side surface of the recessed portion 12 and the opening of the recessed portion 12, heat is less likely to be generated due to the protruding portion 11a and the metal oxide film 12a and heat is more effectively less likely to be transferred to the insulation layer 41, and thus the insulation layer 41 is less likely to deteriorate. Thus, usage over a long period of time is possible.

The height of the protruding portion 11a from the first surface is equal to or more than a thickness of the insulation layer 41. According to the configuration described above, in a case where the first surface and the bottom surface of the stepped portion 11b are the same surface, the insulation layer 41 is less likely to be irradiated with the emitted light, for example, and the insulation layer 41 is effectively less likely to deteriorate. Thus, usage over a long period of time is possible. In a case where the insulation layer 41 is a resin, it is susceptible to light, and thus the above-described configuration makes it easier to obtain the effect of making the insulation layer 41 less likely to deteriorate, and the same applies in the following disclosure.

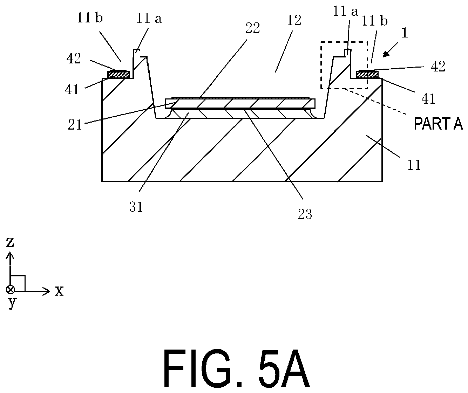

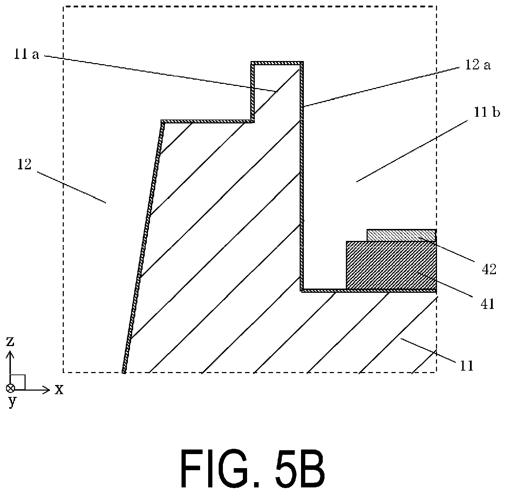

Furthermore, as in the example illustrated in FIGS. 5A and 5B, the protruding portion 11a includes a step. According to the configuration described above, in a case where the light emitting element is used as the electronic component 2, even when the inner side surface of the recessed portion 12 is irradiated with the emitted light, a path in which heat is less likely to be generated due to the metal oxide film 12a is long, and heat is more effectively less likely to be transferred to the insulation layer 41, and thus the insulation layer 41 is less likely to deteriorate. Thus, usage over a long period of time is possible.

Furthermore, as in the example illustrated in FIGS. 5A and 5B, the depth inside the stepped portion 11b located on the first surface of the metal substrate 11 is larger than the thickness of the insulation layer 41. According to the configuration described above, the insulation layer 41 is less likely to be directly irradiated with the light of the light emitting element, and the insulation layer 41 is less likely to deteriorate. Thus, usage over a long period of time is possible.

Furthermore, as in the example illustrated in FIGS. 4A to 5B, the insulation layer 41 is located away from the side surface of the stepped portion 11b. According to the configuration described above, heat is further less likely to be transferred to the insulation layer 41, and the insulation layer 41 is less likely to deteriorate. Thus, usage over a long period of time is possible.

Furthermore, as in the example illustrated in FIGS. 4A to 5B, an outer edge side of the stepped portion 11b where the insulation layer 41 is located is open. According to the configuration described above, heat is less likely to remain inside the stepped portion 11b, and the insulation layer 41 is less likely to deteriorate. Thus, usage over a long period of time is possible.

The electronic component mounting package 1 of the second embodiment can be manufactured using the same manufacturing method as that of the electronic component mounting package 1 of the embodiment described above.

The present invention is not limited to the above-described embodiments, and various modifications are applicable. For example, the insulation substrate plate 21 may have a rectangular shape with a cut out portion or chamfer in a side surface or corner portion in plan view.

Furthermore, in the electronic component mounting package 1 according to the first embodiment and the electronic component mounting package 1 according to the second embodiment, the recessed portion 12 is formed as a space having a quadrangular trapezoid shape with a large opening side on the first surface of the metal substrate 11, but may be formed as a space having a conical trapezoid shape with a large opening side on the first surface of the metal substrate 11. Furthermore, the recessed portion 12 may be formed as a space having a rectangular parallelepiped shape on the first surface of the metal substrate 11. The recessed portion 12 is formed on the first surface of the metal substrate 11 so that the opening side becomes larger as in the electronic component mounting package 1 according to the first embodiment and the electronic component mounting package 1 according to the second embodiment, and thus the light of the light emitting element mounted on the insulation substrate plate 21 can be favorably released to the outside.

Furthermore, the electronic component mounting package 1 in the above-described embodiment includes one recessed portion 12 on the first surface of the metal substrate 11 and the insulation substrate plate 21 in the recessed portion 12; however, the electronic component mounting package 1 may be obtained by forming a plurality of the recessed portions 12 on the first surface of the metal substrate 11 and bonding the insulation substrate plate 21 to the bottom surface of each recessed portion 12 via the bonding material 31. In the above case, the electronic component 2 may be mounted on the insulation substrate plate 21 placed on the bottom surface of each recessed portion 12.

### Reference Signs List

1 Electronic component mounting package
11 Metal substrate
11a Protruding portion
12 Recessed portion
12a Metal oxide film
13 Mounting portion
21 Insulation substrate plate
22 Mounting layer
23 Bonding layer
31 Bonding material
2 Electronic component
3 Connection member
41 Insulation layer
42 Wiring conductor

## Claims

1. An electronic component mounting package comprising:
a metal substrate comprising a first surface, a recessed portion opening on the first surface, and a mounting portion for an electronic component in the recessed portion; and
a wiring conductor located on the first surface via an insulation layer other than at the opening of the recessed portion wherein
at least a part of an inner side surface of the recessed portion comprises a metal oxide film.

2. The electronic component mounting package according to claim 1, wherein
the metal oxide film is located from the opening of the recessed portion to a height of the mounting portion on the inner side surface of the recessed portion.

3. The electronic component mounting package according to claim 1 or 2, wherein
the inner side surface of the recessed portion is inclined and the opening of the recessed portion is located outside a boundary between the bottom surface of the recessed portion and the inner side surface connected to the bottom surface.

4. The electronic component mounting package according to any one of claims 1 to 3, further comprising:
a protruding portion protruding from the first surface between the opening in the recessed portion and the insulation layer, wherein
the metal oxide film is located from an inner side surface of the recessed portion to the protruding portion.

5. The electronic component mounting package according to claim 4, wherein
the metal oxide film covers the protruding portion.

6. The electronic component mounting package according to claim 5, wherein
the metal oxide film further extends to the insulation layer.

7. The electronic component mounting package according to any one of claims 1 to 6, wherein
a height of the protruding portion from the first layer is equal to a thickness of the insulation layer or more.

8. An electronic device, comprising:
the electronic component mounting package according to any one of claims 1 to 7; and
an electronic component mounted on the electronic component mounting package.
